# EUROPÄISCHE PATENTSCHRIFT

(11) **EP 0 720 298 B1**
(45) Veröffentlichungstag und Bekanntmachung des Hinweises auf die Patenterteilung: **17.09.1997**
(21) Anmeldenummer: 95119503.1
(22) Anmeldetag: 11.12.1995
(51) Int. Cl.: H03L 1/02

(54) **Verfahren zur Kompensierung des Temperaturganges einer Oszillatorschaltung**
Method for compensating the temperature characteristic of an oscillator circuit
Procédé de compensation de la caractéristique de température d'un circuit oscillateur

(30) Priorität: 28.12.1994 DE 4447001
(43) Veröffentlichungstag der Anmeldung: 03.07.1996
(73) Patentinhaber: SIEMENS AKTIENGESELLSCHAFT, 80333 München (DE)
(72) Erfinder: Wewers, Otger, Dipl.-Ing., D-46395 Bocholt (DE); Hinske, Martin, Dipl.-Ing., D-46354 Südlohn (DE)

(56) Entgegenhaltungen:
- EP-A- 0 608 681
- WO-A-88/01810
- DE-A- 4 209 843
- US-A- 4 967 165

## Beschreibung

Die Erfindung betrifft ein Verfahren zur Kompensierung des Temperaturganges einer Oszillatorschaltung gemäß dem Oberbegriff des Patentanspruchs 1.

Aus der DE-A-42 09 843 ist ein Verfahren zur Kompensierung des Temperaturganges einer Oszillatorschaltung bekannt, bei dem eine Kalibriereinrichtung mit einem Frequenzregelkreis und einem digitalen Speicher vorgesehen ist. Unter Anlegen eines externen Referenzsignals wird eine Selbstkalibrierung der Oszillatoranordnung ermöglicht.

Eine temperaturkompensierte Oszillatorschaltung, ein sogenannter DTCXO (Digitally Temperature Compensated Crystal Oscillator) ist vor allem im Hinblick auf eine automatische Fertigung sehr flexibel. Bei ihr wird das analoge Signal eines Temperaturfühlers durch einen A/D-Wandler in eine digitale Temperatur-Adresse umgewandelt, unter der in einem Speicher der zur Kompensation notwendige digitale Korrekturwert abgelegt ist. Dieser wird mit Hilfe eines D/A-Wandlers als analoge Regelspannung einem spannungsgesteuertem Oszillator zugeführt. Dies bewirkt eine stückweise Korrektur der temperaturbedingten Frequenzabweichung.

Der DTCXO ist gut für eine automatisierte Herstellung geeignet. Die jeweiligen Temperaturwerte und die zugehörigen Korrekturwerte werden in einem vorgegebenen Temperaturbereich aufgenommen, digitalisiert und in einem EPROM-Speicher abgelegt.

Man kann auch den funktionellen Verlauf der Korrekturwerte durch ein Polynom approximieren, dessen Koeffizienten durch einen mathematischen Fit ermittelt werden. Die Steuerspannung für die Korrektur des Oszillators wird dann durch Interpolation in einem Mikroprozessor ermittelt.

Die Temperatur-Charakteristik eines Quarzes hängt vom Schnittwinkel ab, unter dem die Quarzscheibe aus dem Rohling herausgeschnitten wird. Der Temperaturgang des Quarzes mit einem sogenannten AT-Schnitt läßt sich näherungsweise durch eine Parabel dritter Ordnung beschreiben. Der Wendepunkt dieser Parabel liegt im allgemeinen bei ca. 25°C. Die Genauigkeit, mit der diese Schnittwinkel eingehalten werden kann, ist begrenzt. Daher ist es nahezu unmöglich, eine größere Stückzahl von Quarzen mit identischen Temperaturverhalten zu produzieren.

Oszillatorschaltungen mit äußerst geringen Toleranzen sind in der Herstellung und im Abgleich sehr aufwendig. Als äußerst gering wird dabei beispielsweise eine Toleranz von <kleiner plus/minus 2,5 ppm im Temperaturbereich von 0 bis 55°C angesehen.

Der Erfindung liegt die Aufgabe zugrunde, ein Verfahren zur Kompensierung des Temperaturganges einer Oszillatorschaltung anzugeben, das eine äußerst geringe Frequenzabweichung im Temperaturgang ermöglicht und keine aufwendigen Abgleicharbeiten erfordert.

Diese Aufgabe wird erfindungsgemäß durch die im Patentanspruch 1 angegebenen Merkmale gelöst.

Bei dem erfindungsgemäßen Verfahren ist ein Abgleich nur bei einem Temperaturwert notwendig.

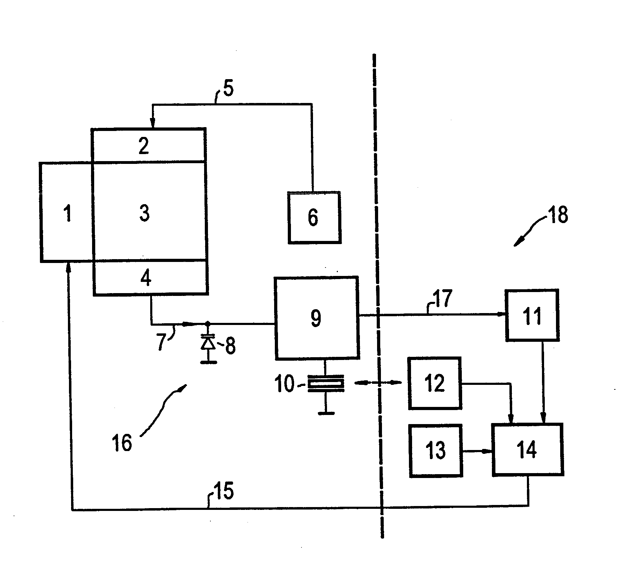

Im folgenden wird die Erfindung anhand eines in der Zeichnung dargestellten Ausführungsbeispieles erläutert.

In der einzigen Figur sind die für das Verständnis der Erfindung notwendigen Einzelheiten einer temperaturkompenstierten Oszillatorschaltung 16 dargestellt.

Diese temperaturkompensierten Oszillatorschaltung 16 weist einen Oszillator 9 auf, an dem ein Oszillator-Quarz angekoppelt ist. In der Nähe des Oszillators 9 ist ein Temperatursensor 6 angeordnet, der über eine Sensorleitung 5 mit einem Analog-Digitalwandler 2 verbunden ist. Dieser Analog-Digitalwandler 2 ist an der Eingangsseite eines Speichers 3 angeordnet, an dessen Ausgangsseite ein Digital-Analogwandler 4 vorgesehen ist. Dieser Digital-Analogwandler 4 ist über eine Steuerleitung 7, an der eine Kapazitätsdiode 8 angekoppelt ist, mit einem entsprechenden Steueranschluß des Oszillators 9 verbunden. Ausgangsseitig wird von dem Oszillator 9 über eine Ausgangsleitung 17 die gewünschte Signalschwingung abgegeben.

Mit dem Speicher 3 ist ein Mikroprozessor 1 verbunden, über den die Schreiblesevorgänge im Speicher 3 und weitere Aufgaben gesteuert werden.

Von dieser temperaturkompensierten Oszillatorschaltung 16 durch eine unterbrochene Linie getrennt ist ein Abgleichsystem 18 dargestellt.

Dieses weist eine Frequenzmeßeinrichtung 11 auf, an der die Ausgangsleitung 17 des Oszillators 9 angeschlossen ist, und die mit der Eingangsseite eines Rechners 14 verbunden ist. Mit der Eingangsseite des Rechners 14 sind auch eine optische Leseeinrichtung 12 und ein Temperatursensor 13 verbunden. Ausgangsseitig ist der Rechner 14 über eine Datenleitung 15 mit dem Mikroprozessor 1 der temperaturkompensierten Oszillatorschaltung 16 verbunden.

Im folgenden wird der Abgleich der temperaturkompensierten Oszillatorschaltung 16 mit Hilfe des Abgleichsystems 18 beschrieben.

Der Temperaturgang des Oszillators-Quarzes 10, d.h. dessen Abhängigkeit der Frequenz von der Umgebungstemperatur, ist beispielsweise beim Hersteller ermittelt worden. Dieser Temperaturgang kann dem Quarz 10 beispielsweise als maschinell lesbarer Code aufgeprägt sein. Dabei kann entweder das Temperaturverhalten in Gruppen eingeteilt sein, oder auch individuell als Wertetabelle auf einem Datenträger abgespeichert sein. Hierbei erfolgt die Zuordnung zwischen dem Datensatz und dem tatsächlichen Quarz über einen auf dem Quarz aufgebrachten Code.

Die Frequenz der von dem Oszillator 9 auf der Ausgangsleitung 17 abgegebenen Signalschwingung wird von der Frequenzmeßeinrichtung 11 ermittelt und an den Rechner 14 gegeben. Von der optischen Leseeinrichtung 12 wird der auf dem Oszillator-Quarz 10 aufgebrachte optische Code gelesen und an den Rechner 14 gegeben. Hierdurch steht im Rechner 14 der Temperaturgang des Quarzes 10 zur Verfügung. Mit dem Temperatursensor 13 wird die Temperatur des Oszillators 9 bzw. der ganzen Baugruppe ermittelt und ebenfalls an den Rechner 14 gegeben.

Das beschriebene Abgleichsystem 18 erfaßt während des Abgleichs die Raumtemperatur, die identisch ist mit der gruppentemperatur, die Istfrequenz des Oszillators 9, den Temperaturcode des Quarzes 10 und die Ziehempfindlichkeit des Oszillators 9. Das Abgleichsystem 18 bestimmt hieraus beispielsweise eine individuelle Korrekturwerttabelle, die über die Datenleitung 15 an den Mikroprozessor 1 gegeben wird. Letztlich wird diese Korrekturwertetabelle im Speicher 3 abgelegt. An Stelle der Korrekturwertetabelle kann auch eine Funktion ermittelt werden und direkt oder durch Vorgabe von Stützwerten abgespeichert werden.

Im folgenden wird die Wirkungsweise der Temperaturkompenstion des Oszillators 9 beschrieben.

In der Nähe des Oszillators 9 ist der Temperatursensor 6 zur Erfassung der Temperatur angeordnet. Der Temperatursensor 6 gibt über die Sensorleitung 5 einen Temperaturwert an den Analog-Digitalwandler 2, der daraus eine Adresse für die im Speicher 3 abgelegte Korrekturwertetabelle bildet. Im Speicher 3 wird der zugehörige Korrekturwert an den Digital-Analogwandler 4 gegeben, der daraus eine Regelspannung bildet und über die Steuerleitung 7 an die Kapazitätsdiode 8 zur Nachregelung des Oszillators 9 gibt.

Der Korrekturwert und damit auch die Nachregelung des Oszillators 9 sind durch den über das Abgleichsystem 18 ermittelten absoluten Fehler sowie den Temperaturgang des tatsächlich eingebauten Oszillator-Quarzes 10 bestimmt.

## Patentansprüche

1. Verfahren zur Kompensierung des Temperaturganges einer Oszillatorschaltung (16) mit einem Oszillator (9) und einem Oszillator-Quarz (10), dessen Schwingungsfrequenz über eine temperaturabhängige Regeleinrichtung (6, 3, 8) nachgeführt wird,
die einen Speicher (3) für Korrekturwerte aufweist, dessen Eingangsvariable ein Temperaturwert ist und dessen Ausgangsvariable dem Oszillator (9) zur frequenzmäßigen Nachführung zugeführt wird,
**dadurch gekennzeichnet,**
daß die Korrekturwerte durch den Temperaturgang des Oszillator-Quarzes (10) und einen gemessenen absoluten Fehler des Oszillators (9) bestimmt sind.

2. Verfahren nach Anspruch 1,
**dadurch gekennzeichnet,**
daß der Temperaturgang des Oszillator-Quarzes (10) optisch lesbar auf dem Quarz (10) aufgebracht ist.

## Claims

1. Method for compensating the temperature response of an oscillator circuit (16) having an oscillator (9) and an oscillator crystal (10) whose oscillation frequency is corrected via a temperature-dependent controlling system (6, 3, 8) which has a memory (3) for correction values, whose input variable is a temperature value and whose output variable is fed to the oscillator (9) for the purpose of correcting frequency, characterized in that the correction values are determined by the temperature response of the oscillator crystal (10) and a measured absolute error of the oscillator (9).

2. Method according to Claim 1, characterized in that the temperature response of the oscillator crystal (10) is applied in an optically readable fashion to the crystal (10).

## Revendications

1. Procédé de compensation de la dérive en température d'un circuit oscillateur (16), comportant un oscillateur (9) et un quartz (10) d'oscillateur, dont la fréquence d'oscillation est suivie par l'intermédiaire d'un dispositif (6, 3, 8) de régulation dépendant de la température,
qui comporte une mémoire (3) de valeurs de correction, dont la variable d'entrée est une valeur de la température et dont la variable de sortie est envoyée à l'oscillateur (9) pour la poursuite de la fréquence,
caractérisé en ce que
les valeurs de correction sont déterminées par la dérive en température du quartz (10) de l'oscillateur et par une erreur absolue mesurée de l'oscillateur (9).

2. Procédé suivant la revendication 1,
caractérisé en ce que
la dérive en température du quartz (10) de l'oscillateur est portée sur le quartz (10) de manière à pouvoir être lue optiquement.
